# EUROPEAN PATENT APPLICATION

(11) **EP 4 642 189 A2**
(43) Date of publication of application: **29.10.2025**
(21) Application number: 25167324.0
(22) Date of filing: 31.03.2025
(51) Int. Cl.: H10D 84/90, H10D 84/85, H10D 89/10, H01L 23/528

(54) **SEMICONDUCTOR DEVICE**

(30) Priority: 26.04.2024 KR 20240056066; 07.05.2024 KR 20240060033; 10.09.2024 KR 20240123415
(71) Applicant: Samsung Electronics Co., Ltd., Suwon-si, Gyeonggi-do 16677 (KR)
(72) Inventor: CHOI, Eunhee, 16677 Suwon-si (KR); KIM, Kibum, 16677 Suwon-si (KR); KIM, Seonkyeong, 16677 Suwon-si (KR); CHO, Yongeun, 16677 Suwon-si (KR); KIM, Hayoung, 16677 Suwon-si (KR)
(74) Representative: Marks & Clerk LLP

(57) **Abstract**

A semiconductor device includes a plurality of power lines, a plurality of standard cells having a reference height corresponding to a reference interval between a pair of power lines supplying different power supply voltages, and a high-voltage cell having a height that is an integer multiple of the reference height and disposed between some of the plurality of standard cells. The high-voltage cell includes at least one wiring line disposed at a height of the plurality of power lines in a direction perpendicular to the upper surface of the substrate. The wiring line is disposed at a position equal to a position of a neighboring power line and is physically separated from the neighboring power line.

## Description

### BACKGROUND

A semiconductor device may include a plurality of semiconductor elements, and may include circuits that operate using different power supply voltages. In order to reduce power consumption of the semiconductor device, there is a trend toward designing a core region with a low power supply voltage. However, a high-voltage circuit operating at a voltage, higher than the power supply voltage supplied to the core region, may be used for operations of the semiconductor device. It is desired to implement the high-voltage circuit to have the same or similar size as standard cells disposed in the core region. It is also desired to implement the high-voltage circuit to have a region for termination that may be disposed around the high-voltage circuit to reduce a degree of integration of the semiconductor device.

### SUMMARY

In general, in some aspects, the present disclosure is directed toward a semiconductor device in which a high-voltage circuit is designed as a standard cell type, and a high-voltage cell providing the high-voltage circuit may be disposed between standard cells without a separate termination region.

According to some implementations, the present disclosure is direction to a semiconductor device comprising: a plurality of power lines extending along a first direction, parallel to an upper surface of a substrate, and disposed along a second direction intersecting the first direction; a plurality of standard cells disposed along the first direction and the second direction, respectively having a reference height corresponding to a reference interval between a pair of power lines that are adjacent to each other in the second direction, the pair of power lines being configured to supply different power supply voltages; and a high-voltage cell having a height that is an integer multiple of the reference height, the high-voltage cell being disposed between the plurality of standard cells. The high-voltage cell includes at least one wiring line disposed at a height of the plurality of power lines in a third direction, the third direction being perpendicular to the upper surface of the substrate. The at least one wiring line is disposed in a position equal to a position of a neighboring power line of the plurality of power lines in the second direction and is physically separated from the neighboring power line in the first direction. For instance, the at least one wiring line may be aligned with the neighboring power line in the first direction, and/or may overlap the neighboring power line in the first direction.

According to some implementations, the present disclosure is directed to a semiconductor device that includes a plurality of power lines extending along a first direction, parallel to an upper surface of a substrate, and disposed along a second direction, intersecting the first direction; a plurality of standard cells disposed along the first direction and the second direction, respectively having a reference height corresponding to a reference interval between a pair of power lines supplying different power supply voltages and being closest to each other in the second direction; and a high-voltage cell having a height that is an integer multiple of the reference height and disposed between some of the plurality of standard cells, wherein the high-voltage cell includes at least one wiring line disposed on a height, equal to a height of the plurality of power lines in a third direction, perpendicular to the upper surface of the substrate, and the wiring line is disposed in a position, equal to a position of a neighboring power line, among the plurality of power lines in the second direction, and is physically separated from the neighboring power line in the first direction.

According to some implementations, the present disclosure is directed to a semiconductor device that includes a plurality of power lines disposed in a plurality of tracks extending along a first direction, parallel to an upper surface of a substrate, and disposed along a second direction, intersecting the first direction; a plurality of standard cells disposed between a pair of closest adjacent tracks separated by a first interval in the second direction, among the plurality of tracks; and at least one high-voltage cell disposed between a pair of tracks, among the plurality of tracks, separated by a second interval, greater than the first interval, in the second direction, wherein at least one additional track other than the pair fo tracks is disposed in the at least one high-voltage cell, wherein a wiring line disposed on the additional track and extending along the first direction is separated from the plurality of power lines, and a voltage of the wiring line disposed on the additional track is different from a voltage of a pair of power lines disposed on the pair of tracks.

According to some implementations, the present disclosure is directed to a semiconductor device that includes a core region operating by a first power supply voltage; and a high voltage (HV) region operating by a voltage, greater than the first power supply voltage, wherein the core region includes a plurality of standard cells disposed along a first direction and a second direction, parallel to an upper surface of a substrate and intersecting each other, and the HV region includes a plurality of high-voltage cells disposed along the first direction and the second direction, and each of the plurality of standard cells has a first height in the second direction, and each of the plurality of high-voltage cells has a second height that is an integer multiple of the first height in the second direction.

The second direction may be parallel to the upper surface of the substrate. The reference height (of the standard cells) may be measured in the second direction. The height of the high-voltage cell may be measured in the second direction. The high-voltage cell may be disposed between at least some of the plurality of standard cells. The high-voltage cell may be disposed between at least two of the plurality of standard cells. The high-voltage cell may be disposed between at least two of the plurality of standard cells in the first direction, and may be disposed between at least two (others) of the plurality of standard cells in the second direction.

A standard cell may be a circuit having a predefined geometry. For instance, a standard cell may have a predefined height (the reference height) in the second direction. A standard cell may have a variable width (e.g. in the first direction). A standard cell may have a predefined functionality. For instance, each standard cell may be configured to implement a basic logic function (e.g. NAND, NOR, XOR, flip-flop, multiplexer, etc.). The plurality of standard cells may comprise standard cells of differing types (e.g. having differing predefined functionalities).

A high-voltage cell may be a cell configured to receive and/or operate using a voltage that is higher than a voltage that is received and/or used by the plurality of standard cells. For instance, a high-voltage cell may be a cell configured to receive and/or operate using a voltage that is higher than a maximum voltage of a standard cell. Accordingly, the term "high-voltage" need not imply any specific magnitude of voltage, but may imply a relative magnitude (e.g. higher than a voltage (e.g. a power supply voltage) of the plurality of standard cells). The voltages discussed herein may be potential differences relative to a reference voltage. For instance, the voltages discussed herein may be potential differences relative to a second power supply voltage (e.g. VSS) that is lower than a first power supply voltage (e.g. VDD).

The high-voltage cell may include at least one wiring line disposed at a height (e.g. a level) of the plurality of power lines in a third direction that is perpendicular to the upper surface of the substrate. The at least one wiring line may overlap the plurality of power lines in at least one of the first and second directions.

The at least one wiring line may be positioned adjacent to a neighboring power line of the plurality of power lines in the first direction. The at least one wiring line may be physically separated from a neighboring power line in the first direction. The at least one wiring line overlap or may be aligned with the neighboring power line in the first direction. The at least one wiring line may be separated from the plurality of lines in the first and second directions.

In certain embodiments, the semiconductor device further comprises one or more voltage supply circuits configured to supply the voltages discussed herein to the plurality of power lines and the at least one wiring line. The one or more voltage supply circuits may be configured to generate one or more of the voltages discussed herein. For instance, the one or more voltage supply circuits may be configured to provide a high voltage and one or more power supply voltages, wherein the high voltage has a higher magnitude than the one or more power supply voltages. The one or more voltage supply circuits may be may configured to provide a first power supply voltage (e.g. VDD) and a second power supply voltage (e.g. VSS) that is less than the first power supply voltage. The high voltage may be provided to the high-voltage cell, and the one or more power supply voltages may be provided to the plurality of standard cells. One or more of the power supply voltages (e.g. the second power supply voltage) may be provided to the high-voltage cell.

The plurality of power supply lines may comprise a first power supply line configured to receive a first power supply voltage and a second power supply line configured to receive a second power supply voltage that is less than the first power supply voltage. The semiconductor device may comprise a high-voltage wiring line configured to receive a high voltage that has a greater magnitude than the first power supply voltage. The high-voltage cell may comprise a plurality of elements connected in series between the high voltage line and the second power supply line, wherein each of the plurality of elements is configured to receive a potential difference that is less than the potential difference between the high voltage and the second power supply voltage.

At least some of the above and other features of the invention are set out in the claims.

### BRIEF DESCRIPTION OF THE DRAWINGS

Example implementations will be more clearly understood from the following detailed description, taken in conjunction with the accompanying drawings.
FIG. 1 is a block diagram illustrating an example of a semiconductor device according to some implementations.
FIGS. 2A and 2B are views illustrating example elements included in a semiconductor device according to some implementations.
FIGS. 3 and 4 are views illustrating an example of a semiconductor device according to some implementations.
FIG. 5 is a view illustrating an example of a high-voltage cell of a standard cell type included in a semiconductor device according to some implementations.
FIGS. 6 to 8 are views illustrating an example of a high-voltage cell of a standard cell type included in a semiconductor device according to some implementations.
FIG. 9 is a circuit diagram illustrating an example of a high-voltage circuit provided by a high-voltage cell disposed in a high-voltage region in a semiconductor device according to some implementations.
FIG. 10 is a view illustrating an example of a core region in a semiconductor device according to some implementations.
FIGS. 11 and 12 are views illustrating examples of high-voltage cells that may be disposed in a core region in a semiconductor device according to some implementations.
FIG. 13 is a circuit diagram illustrating an example of a high-voltage circuit provided by a high-voltage cell disposed in a core region in a semiconductor device according to some implementations.
FIG. 14 is a view illustrating an example of a high-voltage cell that may be disposed in a core region in a semiconductor device according to some implementations.

### DETAILED DESCRIPTION

Hereinafter, example implementations will be described with reference to the accompanying drawings.

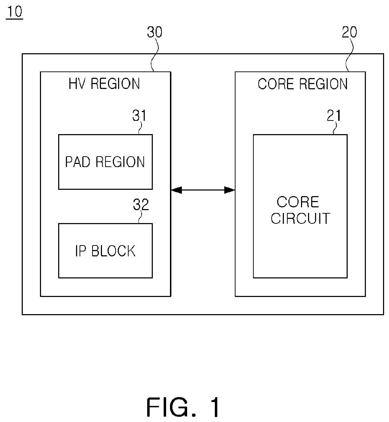

FIG. 1 is a block diagram illustrating an example of a semiconductor device according to some implementations. In FIG. 1, a semiconductor device 10 may include a core region 20 and a high voltage (HV) region 30. The core region 20 may include a core circuit 21 that executes various functions, and the core circuit 21 may be implemented with standard cells. A pad region 31, an intellectual property (IP) block 32, and the like may be disposed in the HV region 30. The pad region 31 may include a plurality of pads exposed externally and electrically connected to a different semiconductor device, another substrate, and/or the like, an electrostatic discharge (ESD) protection circuit connected to the plurality of pads, and the like. The IP block 32 may be a functional block implemented to perform a specific function.

Different power supply voltages may be supplied to elements included in the core region 20 and elements included in the HV region 30. For instance, one or more circuits in the core region 20 may be configured to operate at different power supply voltage(s) to one or more circuits in the HV region 30. For example, a power supply voltage supplied to the elements disposed in the core region 20 may be lower than a power supply voltage supplied to the elements disposed in the HV region 30. For instance, one or more circuits in the core region 20 may be configured to operate at across a lower potential difference than one or more circuits disposed in the HV region 30. Due to such a difference in power supply voltage, a swing range between an input voltage and an output voltage of a circuit disposed in the HV region 30 may also be different from a swing range between an input voltage and an output voltage of a circuit disposed in the core region 20.

In some implementations, a high-voltage circuit operating at a voltage, higher than the power supply voltage supplied to the core region 20, or inputting and outputting a voltage, higher than the power supply voltage supplied to the core region 20, may be included in the core circuit 21. In this case, the high-voltage circuit may be implemented by partially disposing an element that may withstand a voltage, higher than the power supply voltage supplied to the core region 20 in the core region 20. In the above method, since elements having different specifications should be formed in the core region 20, the number of process operations may increase. In addition, in a case in which an element having a gate-all-around (GAA) structure, which has been recently proposed to improve a degree of integration of the semiconductor device 10, may be applied to the core region 20, there may be a limit to increasing a thickness of a gate insulating layer, making it difficult to form an element that may withstand a voltage, higher than the power supply voltage supplied to the core region 20, in the core region 20.

In some implementations, a high-voltage circuit inputting/outputting a voltage higher than the power supply voltage supplied to the core region 20, or using the voltage higher than the power supply voltage supplied to the core region 20 may be implemented using only elements that may be applied up to the power supply voltage supplied to the core region 20. To this end, the high-voltage circuit may include at least one tolerant element.

In addition, in some implementations, the high-voltage circuit may be implemented as a high-voltage cell of a standard cell type, rather than a macro cell or the like including a separate termination region. For example, a high-voltage cell implementing the high-voltage circuit may be continuously disposed to be adjacent to the standard cells included in the core circuit 21 without a separate termination region. To this end, a height of the high-voltage cell may correspond to an integer multiple of a height of each of the standard cells included in the core circuit 21. By designing the high-voltage cell having the height corresponding to an integer multiple of the height of each of the standard cells included in the core circuit 21, a difference in voltage between adjacent wiring patterns may be reduced and conditions required by the design rule of the semiconductor device 10 may be satisfied.

Considering a difference between a voltage used by the elements in the core region 20 and a voltage used by the elements in the HV region 30, the elements included in the core region 20 and the elements included in the HV region 30 may have different specifications. For example, a maximum voltage that may be applied to each of the elements included in the core region 20 may be less than a maximum voltage that may be applied to each of the elements included in the HV region 30. Considering a difference in maximum voltage, for example, a thickness of a gate insulating layer included in an element disposed in the core region 20 may be less than a thickness of a gate insulating layer included in an element disposed in the HV region 30.

As described above, due to structural characteristics of an element included in the semiconductor device 10, there may be a limit to increasing a thickness of a gate insulating layer. Accordingly, the elements included in the core region 20 and the elements included in the HV region 30 may have the same specifications, and for example, the thickness of the gate insulating layer included in the element disposed in the core region 20 may be the same as the thickness of the gate insulating layer included in the element disposed in the HV region 30.

In this manner, even when the elements included in the core region 20 and the elements included in the HV region 30 have the same specifications, an input voltage, an output voltage, a power supply voltage, or the like of the circuit provided by the elements in the HV region 30 may be relatively greater than an input voltage, an output voltage, a power supply voltage, or the like of the circuit provided by the elements in the core region 20. Accordingly, in order for the elements in the HV region 30 to withstand a relatively high input voltage, a relatively high output voltage, a relatively high power supply voltage, or the like, the circuit in the HV region 30 may include a tolerant element limiting the maximum voltage applied to each of the elements.

In a case in which the elements included in the core region 20 and the elements included in the HV region 30 have the same specifications, the pad region 31 and/or the IP block 32 in the HV region 30 may also be implemented by combining high-voltage cells designed to have a standard cell type. The high-voltage cell may have a relatively greater height than the standard cell disposed in the core region 20. This may be to prevent voltages having large differences deviating from a design rule from being applied to adjacent wiring patterns, in a high-voltage cell in which an input voltage, an output voltage, a power supply voltage, or the like is relatively high.

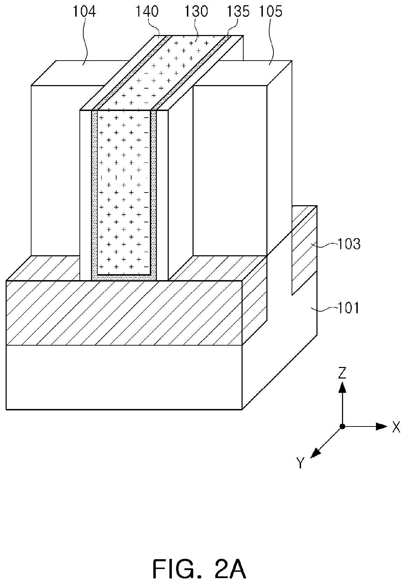

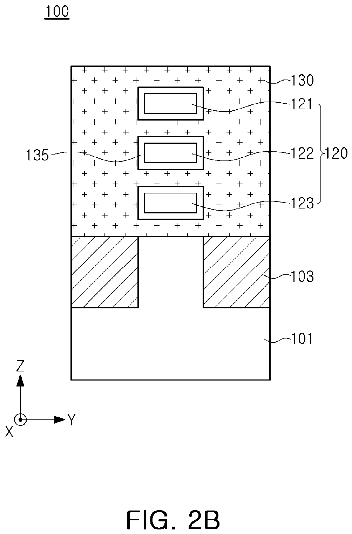

FIGS. 2A and 2B are views illustrating example elements included in a semiconductor device according to some implementations. As described above, a semiconductor device may include an HV region and a core region, and an element 100 described with reference to FIGS. 2A and 2B may be an element disposed in the core region. In some implementations, the element 100 disposed in the core region may have a GAA structure. In some implementations, elements disposed in the HV region may also be implemented to have a GAA structure, as in the element 100 described with reference to FIGS. 2A and 2B.

In FIGS. 2A and 2B, an element 100 may be formed on a substrate 101, and a substrate insulating layer 103 may be formed on the substrate 101 (e.g. on an upper surface of the substrate 101). The substrate 101 may have an upper surface extending in a first direction (X-axis direction) and a second direction (Y-axis direction). The substrate 101 may include a vertical region extending in a third direction (Z-axis direction) between substrate insulating layers 103, and active regions 104 and 105 and a gate electrode layer 130 may be disposed on the vertical region of the substrate 101. The vertical region may protrude from the upper surface of the substrate 101. The active regions 104 and 105 provide a source region and a drain region of the element 100, may be disposed in the first direction (X-axis direction), parallel to the upper surface of the substrate 101, and may extend in the third direction. The third direction may be perpendicular to the upper surface of the substrate 101. The third direction may be perpendicular to the first direction.

The gate electrode layer 130 may be disposed between the active regions 104 and 105 in the first direction, and may extend in the third direction and the second direction (Y-axis direction). The second direction may be parallel to the upper surface of the substrate 101. The second direction may be perpendicular to the first and third directions. A gate insulating layer 135 and a spacer 140 may be disposed between the gate electrode layer 130 and the active regions 104 and 105.

A plurality of channel regions 120 (121 to 123) may be disposed between the active regions 104 and 105 in the first direction. In FIG. 2B, the plurality of channel regions 120 may extend in the first direction, and may be connected to the active regions 104 and 105 at both sides, and the plurality of channel regions 120 may be separated from each other in the third direction. The plurality of channel regions 120 may be surrounded by the gate electrode layer 130 in the second direction and the third direction, and the gate insulating layer 135 may also be disposed between the plurality of channel regions 120 and the gate electrode layer 130.

In FIG. 2A and FIG. 2B, circuits disposed in a core region and/or an HV region of a semiconductor device may be implemented as the element 100 with a GAA structure, to improve a degree of integration of the semiconductor device. As a size of the element 100 decreases, a maximum voltage that may be applied to the element, e.g., a maximum voltage which the element may withstand, decreases, and a method for implementing a high-voltage circuit operating with a power supply voltage, greater than the maximum voltage that the element 100 may withstand, may be required. In particular, high-voltage circuits disposed in the HV region, such as an HV inverter, an HV buffer, or the like may operate with an input voltage, an output voltage, a power supply voltage, or the like, greater than the maximum voltage that the element 100 may withstand. The maximum voltage which the element may withstand may be the maximum potential difference across at least two terminals of the element that the element may withstand whilst continuing to operate normally. This may be the maximum voltage before breakdown occurs (e.g. dielectric breakdown, avalanche breakdown, etc.), or before the element is damaged. For instance, the maximum voltage for a transistor may be the breakdown voltage of the transistor.

For example, the maximum voltage that may be applied to the element 100 may increase to implement a high-voltage circuit operating with a relatively high power supply voltage. The maximum voltage that may be applied to the element 100 may increase by structural changes, such as an increase in thickness of the gate insulating layer 135. In the element 100 having the GAA structure, as shown in FIGS. 2A and 2B, it may be difficult to increase the thickness of the gate insulating layer 135, and it may be difficult to increase the maximum voltage that the element 100 may withstand.

In some implementations, a high-voltage circuit operating at a power supply voltage, greater than the maximum voltage that the element 100 may withstand, may be implemented by using only the element 100 of one type having the same thickness of the gate insulating layer 135. To this end, some of elements 100 included in the high-voltage circuit may function as a tolerant element receiving a predetermined bias voltage, and a voltage applied to each of the elements 100 included in the high-voltage circuit by the tolerant element may be limited up to the maximum voltage applied to the elements 100.

In some implementations, the high-voltage circuit may be implemented by a high-voltage cell designed as a standard cell type. For example, a plurality of standard cells for implementing a core circuit may be disposed in the core region of the semiconductor device, and each of the standard cells may have a height according to a predetermined specification. In some implementations, the height of the standard cell may be an interval (distance) between a pair of power lines, adjacent to each other and extending along a boundary of the standard cell.

In the high-voltage cell, elements 100 for implementing a high-voltage circuit may be disposed, and a voltage, higher than a maximum voltage that the elements 100 may withstand, may be applied to at least one of the elements 100 as an input voltage, an output voltage, a power supply voltage, or the like. Accordingly, to sufficiently secure an interval between wiring patterns to which voltages having a difference, greater than a predetermined reference level, are applied, the high-voltage cell may be designed to have a height, greater than a height of the standard cell. In some implementations, the height of the high-voltage cell may be an integer multiple of the height of the standard cell.

In some implementations, the high-voltage circuit may include a level shifter increasing or decreasing an input voltage and outputting the same, and a height of the high-voltage cell providing the level shifter may also be an integer multiple of the height of the standard cell. Accordingly, the high-voltage cell providing the level shifter may be disposed between some of the standard cells disposed in the core region without a separate termination region. For example, among wiring lines included in the high-voltage cell, a wiring line supplying a voltage equal to the power supply voltage supplied to the standard cells in the core region may be physically connected to a wiring line of the standard cell adjacent to the high-voltage cell. Accordingly, the high-voltage cell providing the level shifter for increasing or decreasing a voltage may be disposed, together with the standard cells, in the core region without a separate termination region, and a degree of integration of the semiconductor device may be improved.

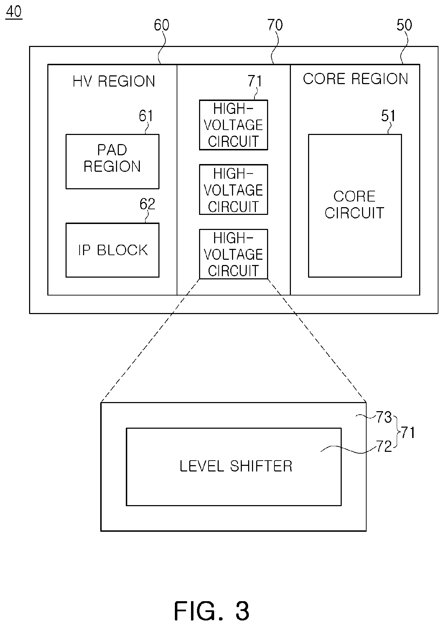

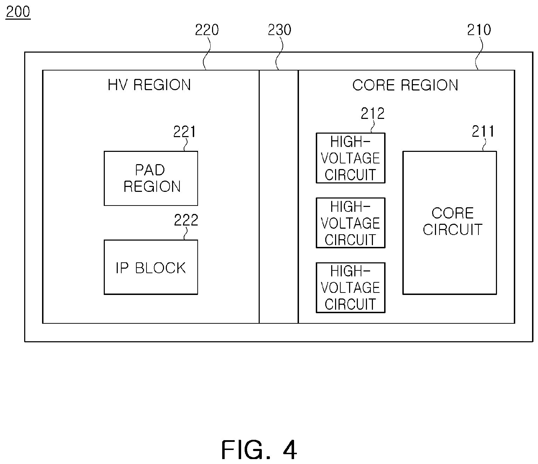

FIGS. 3 and 4 are views illustrating an example of a semiconductor device according to some implementations. In FIG. 3, a semiconductor device 40 may include a core region 50, an HV region 60, and an intermediate region 70. As described above with reference to FIG. 1, a core circuit 51 may be disposed in the core region 50, and a pad region 61, an IP block 62, and the like may be disposed in the HV region 60.

As described above, a circuit included in the core circuit 51 and a circuit included in the pad region 61 and the IP block 62 may operate using different voltages from each other, in view of an input voltage, an output voltage, a power supply voltage, or the like. For example, as compared to an ESD protection circuit included in the pad region 61, the core circuit 51 may input and output a relatively low input voltage and a relatively low output voltage, and may operate with a relatively low power supply voltage. Considering such a difference in voltage, a high-voltage circuit 71, such as a level shifter 72 or the like increasing or decreasing the voltage, may be disposed in the intermediate region 70 between the core region 50 and the HV region 60.

In FIG. 3, a termination region 73 may be disposed around the level shifter 72. A plurality of finishing cells may be disposed in the termination region 73, and a predetermined separation space may exist between elements included in the level shifter 72 and the plurality of finishing cells. Accordingly, the high-voltage circuit 71 may be implemented with a structure including a circuit such as the level shifter 72 or the like performing an actual operation, and the termination region 73 therearound, and may dispose the same separately in the intermediate region 70, to reduce a degree of integration of the semiconductor device 40.

In some implementations, a high-voltage circuit, such as a level shifter, may be implemented as a standard cell type, and may be disposed in a core region 210. In FIG. 4, a semiconductor device 200 may include a core region 210, an HV region 220, and an intermediate region 230. In a FIG. 4, the intermediate region 230 may be disposed to separate the core region 210 and the HV region 220, and a high-voltage circuit 212 including a level shifter may be disposed in the core region 210, not in the intermediate region 230. Accordingly, an area of the intermediate region 230 may be reduced to improve a degree of integration of the semiconductor device 200.

The high-voltage circuit 212 including the level shifter for increasing or decreasing a voltage may be designed as a standard cell type, and may be disposed in the core region 210, together with a core circuit 211. The core circuit 211 may include standard cells, and the high-voltage circuit 212 may be disposed between some of the standard cells. The high-voltage circuit 212 may be implemented as a high-voltage cell designed as a standard cell type that does not include a separate termination region, and the high-voltage cell may be disposed to be continuously adjacent to some of the standard cells. The high-voltage cell may have a height, greater than a height of each of the standard cells.

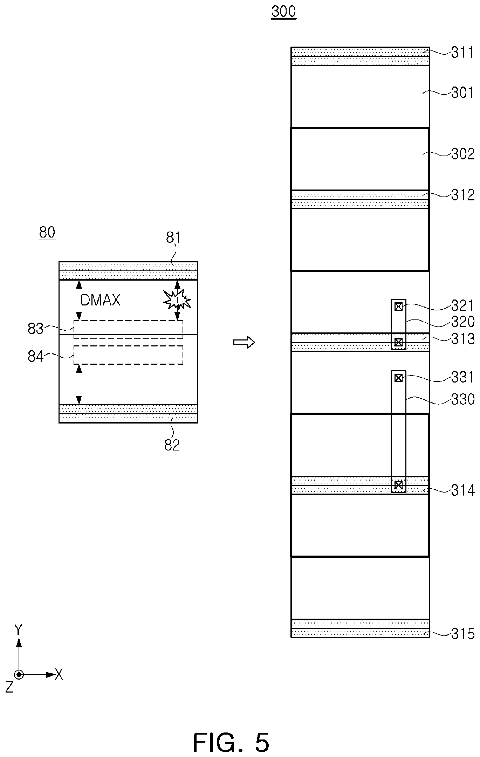

In some implementations, not only the high-voltage circuit 212 disposed in the core region 210 together with the standard cells and providing the level shifter increasing or decreasing a voltage, but also circuits included in a pad region 221 and an IP block 222 of the HV region 220 may be designed as high-voltage cells of a standard cell type. The high-voltage cell for implementing the circuits of the HV region 220 may have a height, greater than a height of the standard cell disposed in the core region 210. This may be to secure a sufficient interval between voltage transmission paths in the high-voltage cell operating at a relatively high voltage, as compared to the standard cell in the core region 210. Hereinafter, this will be described in more detail with reference to FIG. 5.

FIG. 5 is a view illustrating an example of a high-voltage cell of a standard cell type included in a semiconductor device according to some implementations. In FIG. 5, a standard cell 80 disposed in a core region and a high-voltage cell 300 disposed in an HV region are illustrated in a semiconductor device. While the standard cell 80 may have a first height H1, the high-voltage cell 300 may have a second height H2, greater than the first height H1. The first height H1 may be defined as an interval between a pair of power lines 81 and 82 extending along a boundary of the standard cell 80 in a first direction (X-axis direction), and adjacent in a second direction (Y-axis direction). In some implementations, the second height H2 may be an integer multiple of the first height H1. The first direction (X-axis direction) and second direction (Y-axis direction) may be parallel to an upper surface of the substrate. A third direction (Z-axis direction) may be perpendicular to the upper surface of the substrate.

In the standard cell 80, a first power supply voltage may be supplied to a first power line 81, and a second power supply voltage, lower than the first power supply voltage, may be supplied to a second power line 82. For example, the second power supply voltage may be a reference voltage. In designing the HV region, to secure reliability of the semiconductor device, when a difference in voltage respectively applied to adjacent wirings in the second direction is equal to or greater than a predetermined reference difference, the wires need to be separated by a certain distance or more. When the HV region is formed with the standard cell 80 having the first height H1, a maximum interval DMAX between the power lines 81 and 82 and different wiring lines 83 and 84 disposed on a height, equal to a height of the power lines 81 and 82 in a third direction (Z-axis direction), perpendicular to an upper surface of a substrate, may not be sufficiently secured.

In some implementations, a voltage swinging between the first power supply voltage and the second power supply voltage may be applied to a first wiring line 83. In this case, the maximum interval DMAX between the first wiring line 83 and the first power line 81 may not be sufficiently secured to be equal to or greater than a maximum interval according to a design rule. Accordingly, designing the HV region using the standard cell 80 may not be possible.

In some implementations, a high-voltage cell 300 may be designed with the second height H2, different from the first height H1 of the standard cell 80, and an HV region may be formed with the high-voltage cell 300. In FIG. 5, the high-voltage cell 300 may include a plurality of power lines 311 to 315 extending in the first direction (X direction) and separated from each other in the second direction (Y direction), and some of the plurality of power lines 311 to 315 may be assigned as a transmission path of a voltage, different from the first power supply voltage and the second power supply voltage. In FIG. 5, the first power supply voltage may be transmitted to a second power line 312, the second power supply voltage, lower than the first power supply voltage, may be transmitted to a first power line 311 and a fifth power line 315, and a third power line 313 and a fourth power line 314 may be assigned as wiring lines that may be a transmission path of a voltage, different from the first and second power supply voltages. Unlike the power lines (311 and 315) extending along a boundary of the high-voltage cell 300, the wiring lines (313 and 314) transmitting voltages, different from a power supply voltage, may extend in the first direction while crossing an internal space of the high-voltage cell 300.

To improve a degree of integration of the semiconductor device, the standard cell 80 and the high-voltage cell 300 may be formed of elements having the same scale, and may include elements of a GAA structure, for example. A maximum voltage that may be applied to each of the elements included in the high-voltage cell 300 may be lower than the first power supply voltage applied to the high-voltage cell 300. For instance, a maximum potential difference applied across each of the elements may be lower than a high-voltage that is supplied to the high-voltage cell. Therefore, a high-voltage circuit implemented with the high-voltage cell 300 may include at least one tolerant element for limiting the voltage applied to each of the elements. By including the tolerant element, the high-voltage circuit operating with an input voltage, an output voltage, a power supply voltage, or the like, greater than the maximum voltage that may be applied, may be implemented.

A predetermined bias voltage may be input to a gate of the tolerant element. In FIG. 5, a voltage of each of the third power line 313 and the fourth power line 314 may be a bias voltage input to the gate of the tolerant element. For example, the third power line 313 may be assigned as a transmission path of a first bias voltage, and the fourth power line 314 may be assigned as a transmission path of a second bias voltage, different from the first bias voltage. By a contact 321 and a wiring pattern 320 connected to the third power line 313, the first bias voltage may be input to the tolerant element, and by a contact 331 and a wiring pattern 330 connected to the fourth power line 314, the second bias voltage may be input to the tolerant element.

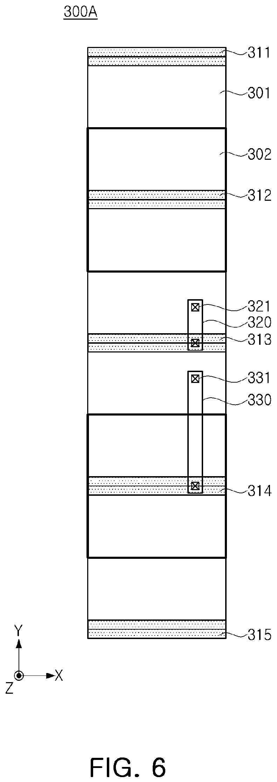

In this manner, the high-voltage cell providing a high-voltage circuit may be designed as a standard cell type, and the HV region of the semiconductor device may be implemented with the high-voltage cell. Accordingly, a degree of integration of the semiconductor device may be improved by omitting a separate termination region or the like surrounding a region in which the high-voltage circuit is implemented. The high-voltage cell may be a cell for implementing an actual high-voltage circuit, and a high-voltage filler cell, a high-voltage tap cell, or the like may be further disposed in the HV region. Hereinafter, a description will be made with reference to FIGS. 6 to 8.

FIGS. 6 to 8 are views illustrating an example of a high-voltage cell of a standard cell type included in a semiconductor device according to some implementations. FIG. 6 is a view illustrating a high-voltage cell 300A providing a high-voltage circuit. A structure of the high-voltage cell 300A may be the same as the implementations described above with reference to FIG. 5. In FIG. 6, a high-voltage cell 300A may include a plurality of power lines 311 to 315 extending in a first direction (X-axis direction) and disposed in a second direction (Y-axis direction), and some of the plurality of power lines 311 to 315 may be assigned as a transmission path of a voltage, other than a first power supply voltage or a second power supply voltage. Among the plurality of power lines 311 to 315, a second power line 312 supplying the first power supply voltage may be disposed on an N-well region 302 in which PMOS transistors are formed.

For example, a third power line 313 and a fourth power line 314 may provide a transmission path of a bias voltage to a tolerant element included in a high-voltage circuit, respectively. The third power line 313, which provides a transmission path of a first bias voltage to a tolerant element implemented as an NMOS transistor, may be disposed on a substrate 301. The fourth power line 314, which provides a transmission path of a second bias voltage to a tolerant element implemented as a PMOS transistor, may be disposed on the N-well region 302. The first bias voltage may be greater than the second bias voltage.

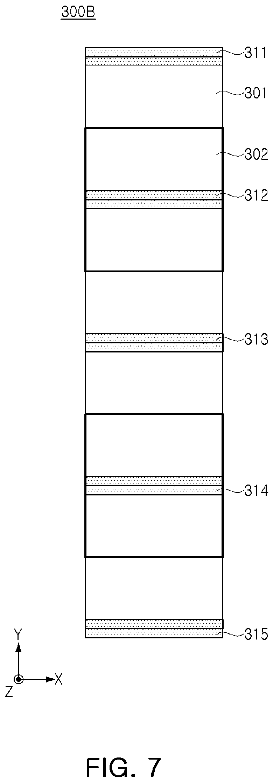

FIG. 7 is a view illustrating a filler cell 300B disposed in an HV region. The filler cell 300B may not include elements necessary for implementing a high-voltage circuit, and may be a kind of dummy cell disposed in a space between high-voltage cells 300A disposed in the HV region. The filler cell 300B may have on a height, equal to a height of the high-voltage cell 300A, and may include a plurality of power lines 311 to 315.

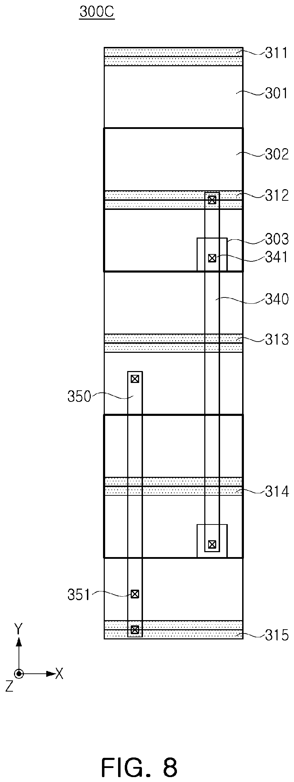

FIG. 8 is a view briefly illustrating a tap cell 300C disposed in an HV region. The tap cell 300C may be a cell for applying a predetermined body bias voltage to a substrate 301, an N-well region 302 formed in the substrate 301, or the like. In FIG. 8, in addition to the N-well region 302 formed in the substrate 301, and a plurality of power lines 311 to 315, the tap cell 300C may further include wiring patterns 340 and 350 for applying a body bias voltage to the substrate 301 and the N-well region 302.

The wiring pattern 340 may extend in the second direction, and may be electrically connected to a second power line 312 by a contact 341. In addition, since the wiring pattern 340 may be electrically connected to an impurity region 303 formed in the N-well region 302, a first power supply voltage may be applied to the N-well region 302. Therefore, the first power supply voltage may be applied as a body bias voltage to a body of a PMOS transistor formed in the N-well region 302.

A fifth power line 315, which provides a transmission path of a second power supply voltage, lower than the first power supply voltage, may be connected to the wiring pattern 350 by a contact 351. In addition, since the wiring pattern 350 may be electrically connected to the substrate 301, the second power supply voltage may be applied to the substrate 301. The substrate 301 may be a P-type substrate doped with a P-type impurity. Accordingly, the second power supply voltage may be applied as a body bias voltage to a body of an NMOS transistor formed on the substrate 301 through the wiring pattern 350.

In FIGS. 6 to 8, an HV region may be designed in a similar manner to a core region designed by a place & routing (P&R) process of standard cells by using various cells (300A, 300B, and 300C). Accordingly, a degree of integration of a semiconductor device may be improved by designing a high-voltage circuit required for the HV region without a separate termination region. In addition, by implementing the HV region with elements of the same scale and the same specifications as those disposed in the core region, the process may be simplified, and yield of the semiconductor device may be improved.

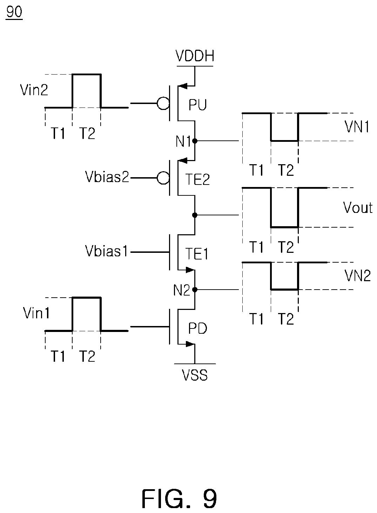

FIG. 9 is a circuit diagram illustrating an example of a high-voltage circuit provided by a high-voltage cell disposed in a high-voltage region in a semiconductor device according to some implementations. In FIG. 9, a high-voltage circuit 90 may be an inverter circuit operating in an HV region. In FIG. 9, a first tolerant element TE1 may be connected to a pull-down element PD which may be an NMOS transistor, and a second tolerant element TE2 may be connected to a pull-up element PU which may be a PMOS transistor. The first tolerant element TE1 may be an NMOS transistor, like the pull-down element PD, and the second tolerant element TE2 may be a PMOS transistor, like the pull-up element PU.

A first input voltage Vin1 may be input to a gate of the pull-down element PD, and a second input voltage Vin2 may be input to a gate of the pull-up element PU. A swing width of the first input voltage Vin1 may be the same as a swing width of the second input voltage Vin2. A minimum voltage of the first input voltage Vin1 may be less than a minimum voltage of the second input voltage Vin2, and a maximum voltage of the first input voltage Vin1 may be less than a maximum voltage of the second input voltage Vin2.

A first bias voltage may be input to a gate of the first tolerant element TE1, and a second bias voltage, less than the first bias voltage, may be input to a gate of the second tolerant element TE2. In some implementations, the first bias voltage may be equal to the maximum voltage of the first input voltage Vin1, and the second bias voltage may be equal to the minimum voltage of the second input voltage Vin2. Each of the first bias voltage and the second bias voltage may be voltages generated by separate bias circuits.

The high-voltage circuit 90 may be implemented in a high-voltage cell of a standard cell type. For example, assuming that the high-voltage circuit 90 is implemented with the high-voltage cell 300A illustrated in FIG. 6, the pull-up element PU may be formed in an N-well region 302 below a second power line 312, and the pull-down element PD may be formed in a substrate 301 adjacent to a first power line 311 or a fifth power line 315. The first tolerant element TE1 may be formed in a region adjacent to a third power line 313 providing a transmission path for the first bias voltage, and the second tolerant element TE2 may be formed in an N-well region 302 below a fourth power line 314 providing a transmission path for the second bias voltage.

During a first time period T1, the pull-up element PU may be turned on, and the pull-down element PD may be turned off. As the pull-up element PU is turned on, a first power supply voltage VDDH may be applied to a first node N1, and a first node voltage VN1 may be set as the first power supply voltage VDDH. The second tolerant element TE2 may be turned on by the second bias voltage Vbias2 input to the gate of the second tolerant element TE2, and thus an output voltage Vout may be set as the first power supply voltage VDDH for the first time period T1.

During a second time period T2, the pull-up element PU may be turned off, and the pull-down element PD may be turned on. As the pull-down element PD is turned on, a second power supply voltage VSS may be applied to a second node N2, and a second node voltage VN2 may be set as the second power supply voltage VSS. The first tolerant element TE1 may be turned on by the first bias voltage Vbias1, and thus the output voltage Vout may be set as the second power supply voltage VSS for the first time period T2. As a result, the output voltage Vout may swing between the first power supply voltage VDDH and the second power supply voltage VSS, and may have a swing range, greater than a swing range between the first input voltage Vin1 and the second input voltage Vin2.

In FIG. 9, the tolerant elements TE1 and TE2 may be connected between the pull-up element PU and the pull-down element PD, a maximum voltage applied across each of all elements (PU, PD, TE1, and TE2) included in the high-voltage circuit 90 may be limited to be less than the first power supply voltage VDDH. In an example embodiment, a maximum voltage of a single element can be defined as a maximum voltage that the single element can withstand without being damaged, and can include a voltage between a source and a drain, a voltage between a gate and a source, and a voltage between a gate and a drain. For example, a maximum voltage applied across each of the elements (PU, PD, TE1, and TE2) may be equal to a difference between a maximum voltage and a minimum voltage at each of the first input voltage Vin1 and the second input voltage Vin2. Accordingly, the high-voltage circuit 90 in the HV region may be implemented with an element of a small scale such as an element disposed in a core region, and difficulty of a manufacturing process of the semiconductor device may be reduced and yield thereof may be improved.

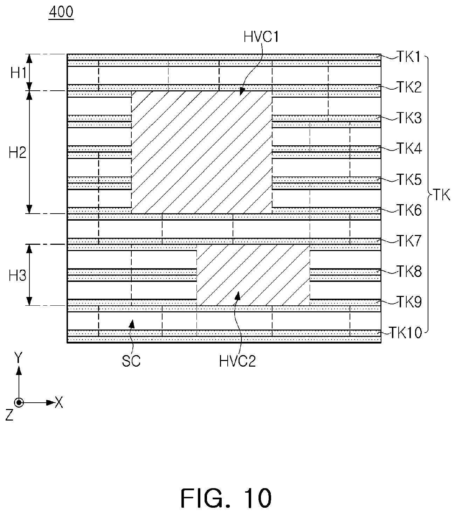

FIG. 10 is a view illustrating an example of a core region in a semiconductor device according to some implementations. In FIG. 10, a plurality of standard cells SC may be disposed in a core region 400 in a first direction (X-axis direction) and a second direction (Y-axis direction), and each of the plurality of standard cells SC may have a first height H1 in the second direction. The first and second directions may be parallel to an upper surface of the substrate. A plurality of tracks TK (TK1 to TK10) extending in the first direction and disposed in the second direction may be defined in the core region 400, and an interval between a pair of closest adjacent tracks in the second direction, among the plurality of tracks TK, may correspond to the first height H1.

For example, the plurality of tracks TK may designate positions in which power lines for supplying power supply voltages required for operations of a circuit provided by each of the plurality of standard cells SC are disposed. In FIG. 10, first power lines supplying a first power supply voltage may be disposed in odd-numbered tracks TK1, TK3, TK5, TK7, and TK9, and second power lines supplying a second power supply voltage, lower than the first power supply voltage, may be disposed in even-numbered tracks TK2, TK4, TK6, TK8, and TK10.

High-voltage cells HVC1 and HVC2 may be disposed between some of the plurality of standard cells SC. The high-voltage cells HVC1 and HVC2 may be cells disposed in the core region 400, as described above with reference to FIG. 4, and may input an input voltage and output an output voltage, higher than the first power supply voltage supplied by power lines disposed along the plurality of tracks TK, or may provide a high-voltage circuit operating with a power supply voltage, higher than the first power supply voltage.

The high-voltage cells HVC1 and HVC2 may have a height, greater than a first height H1 of each of the standard cells SC. In FIG. 10, a first high-voltage cell HVC1 may have a second height H2, and a second high-voltage cell HVC2 may have a third height H3. Each of the second height H2 and the third height H3 may be an integer multiple of the first height H1, and thus the high-voltage cells HVC1 and HVC2 may be disposed between the standard cells SC. In FIG. 10, the high-voltage cells HVC1 and HVC2 may be disposed between the standard cells SC without a separate termination region, and may be directly adjacent to the standard cells SC in the first direction and the second direction.

In some implementations, the high-voltage cells HVC1 and HVC2 may provide a level shifter increasing or decreasing a magnitude of a voltage. In FIG. 10, the first high-voltage cell HVC1 may provide a first level shifter increasing the magnitude of the voltage, and the second high-voltage cell HVC2 may provide a second level shifter decreasing the magnitude of the voltage. The first level shifter may be a circuit increasing and outputting a voltage transmitted from the core region 400 to the HV region such as a pad region or the like. The second level shifter may be a circuit decreasing and outputting a voltage transmitted from the HV region to the core region 400.

Each of the elements included in the high-voltage cells HVC1 and HVC2 may be elements of the same scale and the same specifications as the elements included in the standard cells SC. For example, a maximum voltage that may be respectively applied to elements included in the standard cells SC may be the same as a maximum voltage that may be respectively applied to elements included in the high-voltage cells HVC1 and HVC2. To design the high-voltage cells HVC1 and HVC2 with only elements having a limited maximum voltage that may be applied, the high-voltage circuit provided by each of the high-voltage cells HVC1 and HVC2 may include at least one tolerant element.

A bias voltage may be input to the tolerant element, and the bias voltage input to some of the tolerant elements may be different from the first power supply voltage and the second power supply voltage. In some implementations, wiring lines supplying a voltage, different from the first power supply voltage and the second power supply voltage, may be disposed on remaining tracks except for tracks extending along a boundary of a region in which the high-voltage cells HVC1 and HVC2 are disposed. A transmission path for the bias voltage to the tolerant element may be secured by utilizing the wiring lines.

An input voltage, an output voltage, or the like of a high-voltage circuit may swing to a voltage, higher than the first power supply voltage transmitted by the power lines disposed along the plurality of tracks TK. In addition, at least one of elements included in the high-voltage circuit may need to be applied with a high power supply voltage, higher than the first power supply voltage. Accordingly, each of the high-voltage cells HVC1 and HVC2 may include high-voltage wiring lines to which a voltage, higher than the first power supply voltage, is applied.

The first power lines and the second power lines may be connected to a power mesh disposed above the power lines in a third direction (Z-axis direction). For example, the first power lines may be connected to a first power mesh to which the first power supply voltage is applied, and the second power lines may be connected to a second power mesh to which the second power supply voltage is applied. The high-voltage wiring line transmitting the high power supply voltage may not be connected to a separate power mesh, and may be formed as a separate wiring.

At least one of tracks crossing an internal space of each of the high-voltage cells HVC1 and HVC2 may be provided with a wiring line separated from power lines extending along tracks located at a boundary of adjacent standard cells SC. For example, a wiring line disposed at least one of the third to fifth tracks TK5 crossing an internal space of the first high-voltage cell HVC1 may be physically separated from power lines disposed along the same track along a boundary of the adjacent standard cells SC in the first direction. In this manner, a bias voltage or the like input to the tolerant element may be transmitted through a wiring line physically separated from the power lines in the first direction and disposed in the internal space of the first high-voltage cell HVC1.

The bias voltage input to the tolerant element may be lower than or equal to the first power supply voltage supplied by the first power lines, and may be higher than the second power supply voltage supplied by the second power lines. High voltage wiring lines to which an input voltage and an output voltage swinging up to a voltage, higher than the first power supply voltage, a high power supply voltage, higher than the first power supply voltage, or the like is applied, may be disposed in the internal space of the first high-voltage cell HVC1 while securing a sufficient interval from the second power lines extending along the second track TK2 and the sixth track TK6. Accordingly, the high-voltage wiring lines may be disposed in the internal space of the first high-voltage cell HVC1 without violating a design rule.

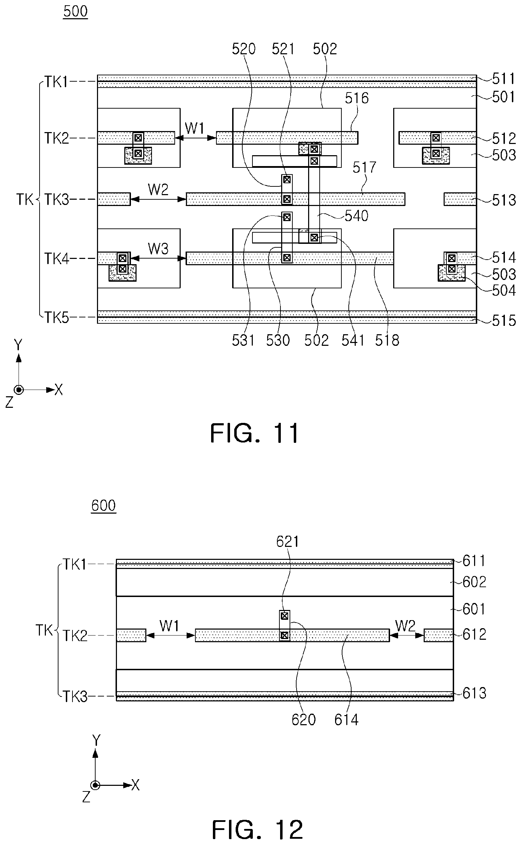

FIGS. 11 and 12 are views illustrating examples of high-voltage cells that may be disposed in a core region in a semiconductor device according to some implementations. FIG. 11 is a view illustrating a high-voltage cell 500 disposed in a core region and providing a level shifter increasing a voltage. In FIG. 11, some of components of the high-voltage cell 500 necessary for providing the level shifter may not be illustrated.

In FIG. 11, a plurality of tracks TK (TK1 to TK5) extending in a first direction (X-axis direction), parallel to an upper surface of a substrate 501 and disposed in a second direction (Y-axis direction) may be defined. The second direction may be parallel to the upper surface of the substrate 501. The second direction may cross (e.g. may be perpendicular to) the first direction. A plurality of power lines may be disposed along the plurality of tracks TK1 to TK5, and as described above with reference to FIG. 10, an interval between a pair of adjacent tracks adjacent to each other in the second direction may be a height of each of standard cells disposed in a core region. A height of a high-voltage cell 500 may be greater than the height of each of the standard cells, and in FIG. 11, the height of the high-voltage cell 500 may be an integer multiple of the height of the standard cell.

The high-voltage cell 500 may be disposed between a pair of first boundaries extending in the first direction and a pair of second boundaries extending in the second direction. The height of the high-voltage cell 500 may be determined by an interval between the first boundaries. The height of the high-voltage cell 500 may be four times the height of the standard cell. Power lines 511 and 515 may be disposed in a first track TK1 and a fifth track TK5 extending along the first boundaries.

In second to fourth tracks TK2 to TK4 located inside the high-voltage cell 500, wiring lines 516 to 518 and power lines 512 to 514, physically separated from each other in the first direction, may be disposed. For example, power lines 512 and 514 disposed in even-numbered tracks TK2 and TK4 may be first power lines supplying a first power supply voltage, and power lines 511, 513, and 515 disposed in odd-numbered tracks TK1, TK3, and TK5 may be second power lines supplying a second power supply voltage, lower than the first power supply voltage.

The wiring lines 516 to 518 may be disposed on a height, equal to heights of the power lines 511 to 515 in a third direction (Z-axis direction). That is, the wiring lines may be located on the same horizontal plane (e.g. the same vertical height in the third direction) as the power lines 511 to 515. The wiring lines 516 to 518 may be located in the second to fourth tracks TK2 to TK4, and thus may be disposed on heights, equal to heights of neighboring power lines 512 to 514, which may be some of the power lines 511 to 515, in the second direction. That is, each of the wiring lines 516 to 518 may be aligned with one of the second to fourth tracks TK2 to TK4, and may therefore be aligned in the second direction with one or more of the power lines 512 to 514.

In addition, the wiring lines 516 to 518 may be physically separated from the neighboring power lines 512 to 514 in the first direction, respectively. In FIG. 11, a first wiring line 516 may be separated from a first neighboring power line 512 by a first width W1, a second wiring line 517 may be separated from a second neighboring power line 513 by a second width W2, and a third wiring line 518 may be separated from a third neighboring power line 514 by a third width W3. At least some of the first to third widths W1 to W3 may be different from each other.

The neighboring power lines 512 to 514 may extend continuously along the boundaries of the high-voltage cell 500 and standard cells adjacent thereto in the first direction. As described above, the first neighboring power line 512 and the third neighboring power line 514 may provide a transmission path of the first power supply voltage, and the second neighboring power line 513 may provide a transmission path of the second power supply voltage.

A plurality of well regions 502 and 503 may be formed in the high-voltage cell 500. A first well region 502 and a second well region 503 may be regions doped with impurities of the same conductivity type, and for example, when the substrate 501 is a P-type substrate, the first well region 502 and the second well region 503 may be N-well regions doped with N-type impurities. A PMOS transistor formed in the first well region 502 and a PMOS transistor formed in the second well region 503 may have different characteristics, and an impurity concentration of the first well region 502 may be different from an impurity concentration of the second well region 503. In FIG. 11, the first well region 502 may be located below the first wiring line 516 and the third wiring line 518, and the second well region 503 may be located below the first neighboring power line 512 and the third neighboring power line 514.

The second well regions 503 may be disposed at both sides of the first well regions 502 in the first direction, and may extend across the second boundaries of the high-voltage cell 500 to standard cells adjacent to both sides of the high-voltage cell 500. For example, an N-well region included in at least one of the standard cells adjacent to the high-voltage cell 500 in the first direction may be provided as a single region with the second well region 503 inside the high-voltage cell 500. PMOS transistors required for the high-voltage cell 500 to implement a high-voltage circuit may be formed in the first well region 502 and the second well region 503, and NMOS transistors may be formed on the substrate 501.

In a case in which the high-voltage cell 500 provides a level shifter increasing a voltage, a tolerant element for limiting a maximum voltage applied to each element of the level shifter may be included in the high-voltage cell 500. In some implementations, the tolerant element included in the level shifter may include a first tolerant element implemented as an NMOS transistor, and a second tolerant element implemented as a PMOS transistor. A first bias voltage may be input to a gate of the first tolerant element, and a second bias voltage, less than the first bias voltage, may be input to a gate of the second tolerant element.

In FIG. 11, the first tolerant element may be formed below the second wiring line 517 extending along the third track TK3. The gate of the first tolerant element may be electrically connected to the second wiring line 517 providing a transmission path of the first bias voltage through a wiring pattern 520 and a contact 521.

The second tolerant element may be formed in the first well region 502. For example, the second tolerant element may be formed in the first well region 502 corresponding to a position of the fourth track TK4. The third wiring line 518 disposed on the fourth track TK4 may be provided as a transmission path of the second bias voltage, and the gate of the second tolerant element may be electrically connected to the third wiring line 518 through a wiring pattern 530 and a contact 531.

An impurity region 504 may be formed in each of the first well regions 502 formed on different positions in the second direction, and the impurity regions 504 may be electrically connected to each other by a wiring pattern 540 and a contact 541. The wiring pattern 540 may be a transmission path of a high power supply voltage, higher than the first power supply voltage supplied by the second power line 512 and the fourth power line 514. The high power supply voltage may be applied to each of the first well regions 502 as a body bias voltage of the PMOS transistor by the wiring pattern 540, the contact 541, or the like.

FIG. 12 is a view illustrating a high-voltage cell 600 disposed in a core region and providing a level shifter reducing a voltage. FIG. 12, like FIG. 11, may not illustrate some of components necessary for providing the level shifter. In some implementations, the level shifter described with reference to FIG. 11 may be disposed in a path through which a signal is transmitted from the core region to the HV region, and the level shifter described with reference to FIG. 12 may be disposed in a path through which a signal is transmitted from a HV region to a core region.

In FIG. 12, a plurality of tracks TK (TK1 to TK3) extending in a first direction (X-axis direction), parallel to an upper surface of a substrate 601 and disposed in a second direction (Y-axis direction) may be defined. The second direction may be parallel to the upper surface of the substrate 501. The second direction may cross (e.g. may be perpendicular to) the first direction. A plurality of power lines 611 to 613 may be disposed along the plurality of tracks TK1 to TK3, and a height of each of standard cells disposed in a core region may be defined by an interval between a pair of adjacent tracks adjacent to each other in the second direction. A height of a high-voltage cell 600 may be greater than the height of each of the standard cells, and the height of the high-voltage cell 600 may be an integer multiple of the height of the standard cell.

The high-voltage cell 600 may be disposed in a pair of first boundaries extending in the first direction and a pair of second boundaries extending in the second direction. The height of the high-voltage cell 600 may be determined by an interval between the first boundaries, and in an embodiment illustrated in FIG. 12, the height of the high-voltage cell 600 may be twice the height of the standard cell. A first power line 611 and a third power line 613 may be disposed in a first track TK1 and a third track TK3 extending along the first boundaries. The first power line 611 and the third power line 613 may supply power supply voltages of the same magnitude, for example, a first power supply voltage.

A second power line 612 and a wiring line 614 may be disposed on a second track TK2. The second power line 612 may supply a second power supply voltage, less than the first power supply voltage. The wiring line 614 may be physically separated from the second power line 612 by a first width W1 at one side in the first direction, and may be physically separated from the second power line 612 by a second width W2 at the other side. In some implementations, the first width W1 and the second width W2 may be the same, or may be different from each other, as illustrated in FIG. 12. The wiring line 614 may be used as a path for transmitting a voltage of a different magnitude from the first power supply voltage and the second power supply voltage.

In FIG. 12, the wiring line 614 may be used as a transmission path of a bias voltage input to a tolerant element. The wiring line 614 may be electrically connected to the tolerant element through a wiring pattern 620 and a contact 621. The tolerant element may be formed on the substrate 601 between well regions 602 formed adjacent to the first track TK1 and the third track TK3, and may be an NMOS transistor, when the substrate 601 is a P-type substrate.

The high-voltage cell 600 may be directly adjacent to other standard cells disposed in the core region in the first direction, the second direction, or the like. For example, there may not be a separate termination region between the high-voltage cell 600 and standard cells adjacent thereto. For example, the well regions 602 may be provided as one region with the well regions of the standard cells adjacent to the high-voltage cell 600 in the first direction and/or the second direction. Additionally, the power lines 611 to 613 may extend continuously along boundaries of standard cells adjacent to the high-voltage cell 600 in the first direction.

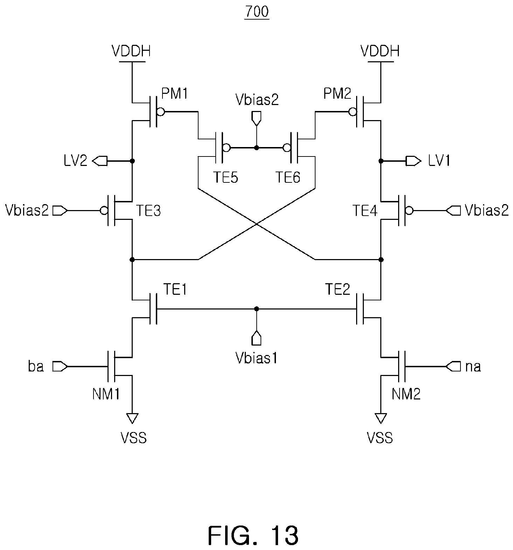

FIG. 13 is a circuit diagram illustrating an example of a high-voltage circuit provided by a high-voltage cell disposed in a core region in a semiconductor device according to some implementations. In FIG. 13, a high-voltage circuit may be a level shifter 700 that increases an input voltage to output an output voltage, and may be implemented by a high-voltage cell 500, as described with reference to FIG. 11, for example. In FIG. 13, the level shifter 700 may include PMOS transistors PM1 and PM2 and NMOS transistors NM1 and NM2, and may also include a plurality of tolerant elements TE1 to TE6 operating with a first bias voltage Vbias1 or a second bias voltage Vbias2.

The level shifter 700 operates with a first power supply voltage VDD, a second power supply voltage VSS, and a high power supply voltage VDDH, greater than the first power supply voltage VDD, and a difference between the high power supply voltage VDDH and a reference voltage VSS may be greater than a maximum voltage that each of elements included in the level shifter 700 may withstand. In FIG. 13, a plurality of tolerant elements TE1 to TE6 may be added to implement the level shifter 700 using only elements of the same specifications and the same scale, without an element that is able to withstand a relatively high maximum voltage.

A first tolerant element TE1 and a second tolerant element TE2 may be implemented with an NMOS transistor, respectively, and may receive the first bias voltage Vbias1 through a gate. Each of third to sixth tolerant elements TE3 to TE6 may be implemented with a PMOS transistor, and may receive the second bias voltage Vbias2 through a gate. The first tolerant element TE1 and the third tolerant element TE3 may be connected between a first NMOS transistor NM1 and a first PMOS transistor PM1, and the second tolerant element TE2 and the fourth tolerant element TE4 may be connected between a second NMOS transistor NM2 and a second PMOS transistor PM2.

A node between the first tolerant element TE1 and the third tolerant element TE3 may be connected to the sixth tolerant element TE6, and a node between the second tolerant element TE2 and the fourth tolerant element TE4 may be connected to the fifth tolerant element TE5. The fifth tolerant element TE5 may be connected to a gate of the first PMOS transistor PM1, the sixth tolerant element TE6 may be connected to a gate of the second PMOS transistor PM2, and a gate of the fifth tolerant element TE5 may be connected to a gate of the sixth tolerant element TE6.

With respect to FIG. 11, the third to sixth tolerant elements TE3 to TE6 may be formed in a first well region 502 corresponding to a position of the fourth track TK4, and may receive the second bias voltage Vbias2 through a third wiring line 518. The PMOS transistors PM1 and PM2 may be formed in the first well region 502 corresponding to a position of the second track TK2, and may receive a high power supply voltage VDDH through a first wiring line 516. The NMOS transistors NM1 and NM2 may be formed on a substrate 501 corresponding to a position of the first track TK1 and/or a position of the fifth track TK5, and the first and second tolerant elements TE1 and TE2 may be formed on the substrate 501 corresponding to a position of the third track TK3. The first bias voltage Vbias1 input to the first and second tolerant elements TE1 and TE2 may be transmitted through a second wiring line 517.

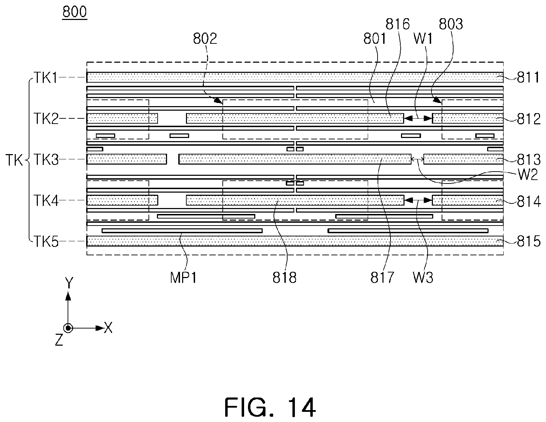

FIG. 14 is a view illustrating a high-voltage cell that may be disposed in a core region in a semiconductor device according to some implementations. In FIG. 14, a plurality of tracks TK1 to TK5 extending in a first direction (X-axis direction) and adjacent in a second direction (Y-axis direction) may be defined in a core region. A first interval between a pair of closest adjacent tracks in the second direction, among the plurality of tracks TK, may correspond to a height of each of standard cells disposed in the core region. A plurality of power lines 811 to 815 may be disposed along the plurality of tracks TK1 to TK5.

A high-voltage cell 800 may be disposed between a pair of tracks TK1 and TK5 separated by a second interval, greater than the first interval in the second direction, among the plurality of tracks TK1 to TK5. In addition, at least one or more additional tracks TK2 to TK4, different from the pair of tracks TK1 and TK5 defining a boundary of the high-voltage cell 800, may be disposed inside the high-voltage cell 800.

Each of the additional tracks TK2 to TK4 may have power lines 812 to 814 and wiring lines 816 to 818 separated in the first direction disposed therein. Intervals W1 to W3 separating the power lines 812 to 814 and the wiring lines 816 to 818 may be different from each other in at least a portion of the additional tracks TK2 to TK4. The wiring lines 816 to 818 may be used as a transmission path of a voltage required for a high-voltage circuit to be implemented with the high-voltage cell 800. For example, a voltage transmitted through at least one of the wiring lines 816 to 818 may be greater than power supply voltages transmitted to the power lines 811 to 815.

The voltage transmitted to the wiring lines 816 to 818 may be different from a voltage transmitted to a pair of power lines 811 and 815 extending along the boundary of the high-voltage cell 800. In FIG. 14, the pair of power lines 811 and 815 extending along the boundary of the high-voltage cell 800 may transmit a second power supply voltage, which may be a reference voltage, and the wiring lines 816 to 818 may transmit a bias voltage input to a tolerant element, a high power supply voltage required for operations of a level shifter, or the like. At least one of the wiring lines 816 to 818 disposed in the additional tracks TK2 to TK4 may overlap a first well region 802 in a third direction (Z-axis direction). When a substrate 801 is a P-type substrate, the first well region 802 may be an N-well region. The first well region 802 overlapping wiring lines 816 and 818 may be separated from a second well region 803 overlapping power lines 812 and 814 by a predetermined distance, and may have different impurity concentrations.

A plurality of wiring patterns MP may be disposed between the plurality of tracks TK1 to TK5. The plurality of wiring patterns MP may be disposed on heights, equal to heights of the plurality of power lines 811 to 815 and the plurality of wiring lines 816 to 818 in the third direction, and may electrically connect at least a portion of elements included in the high-voltage cell 800 to each other.

According to some implementations, various wiring lines and power supply lines are described as being configured to receive various voltages (e.g. a first power supply voltage, a second power supply voltage, a high-voltage, a first bias voltage, a second bias voltage, etc.). The semiconductor device may comprise one or more voltage supply circuits configured to supply the voltages discussed herein to the respective wiring lines and power supply lines. The one or more voltage supply circuits may be configured to generate one or more of the voltages discussed herein.

According to some implementations, a high-voltage circuit operating at a power supply voltage, higher than a limit voltage, may be implemented only with elements having a low limit voltage, which is a maximum voltage that may be applied, and a high-voltage cell providing the high-voltage circuit may be designed as a standard cell type. Accordingly, the high-voltage cell may be disposed between standard cells in a core region without a separate termination region, and a degree of integration of a semiconductor device may be improved. In addition, high-voltage circuits disposed in a high-voltage region separated from the core region and supplied with a relatively higher power supply voltage may also be designed as standard cell types.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following Clauses:
Clause 1. A semiconductor device comprising:
   a plurality of power lines extending along a first direction, parallel to an upper surface of a substrate, and disposed along a second direction, intersecting the first direction;
   a plurality of standard cells disposed along the first direction and the second direction, respectively having a reference height corresponding to a reference interval between a pair of power lines supplying different power supply voltages and being closest to each other in the second direction; and
   a high-voltage cell having a height that is an integer multiple of the reference height and disposed between some of the plurality of standard cells,
   wherein the high-voltage cell includes at least one wiring line disposed on a height, equal to a height of the plurality of power lines in a third direction, perpendicular to the upper surface of the substrate, and
   the wiring line is disposed in a position equal to a position of a neighboring power line, among the plurality of power lines, in the second direction, and is physically separated from the neighboring power line in the first direction.
Clause 2. The semiconductor device of Clause 1,
   wherein the high-voltage cell is disposed in a pair of first boundaries extending along the first direction, and a pair of second boundaries extending along the second direction, and two power lines, among the plurality of power lines, are disposed along the first boundaries.
Clause 3. The semiconductor device of Clause 2, wherein the two power lines supply power supply voltages having the same magnitude.
Clause 4. The semiconductor device of any preceding Clause,
   wherein the wiring line includes a first wiring line disposed in a position equal to a position of a first neighboring power line, among the plurality of power lines, in the second direction, and a second wiring line disposed in a position equal to a position of a second neighboring power line, among the plurality of power lines, in the second direction, and
   wherein the first wiring line and the second wiring line are disposed on different positions in the second direction.
Clause 5. The semiconductor device of Clause 4, wherein a magnitude of a constant voltage supplied by the first wiring line is different from a magnitude of a constant voltage supplied by the second wiring line.
Clause 6. The semiconductor device of Clause 4 or Clause 5, wherein a length of the first wiring line is different from a length of the second wiring line, in the first direction.
Clause 7. The semiconductor device of any of Clauses 4-6, wherein an interval between the first neighboring power line and the first wiring line in the first direction is different from an interval between the second neighboring power line and the second wiring line.
Clause 8. The semiconductor device of any preceding Clause,
   wherein the high-voltage cell comprises a first well region and a second well region, disposed in different positions in the first direction, and
   wherein, in the third direction, the first well region is disposed below the wiring line, and the second well region is disposed below the neighboring power line.
Clause 9. The semiconductor device of Clause 8, wherein the second well region is provided as a single region with a well region included in at least one standard cell adjacent to the high-voltage cell in the first direction.
Clause 10. The semiconductor device of Clause 8 or Clause 9, wherein an impurity concentration of the first well region is different from an impurity concentration of the second well region.
Clause 11. The semiconductor device of any preceding Clause,
   wherein the high-voltage cell further comprises a high-voltage wiring line to which a high voltage is applied,
   wherein a magnitude of the high voltage is higher than a magnitude of the power supply voltages supplied by the plurality of power lines, and
   wherein the high-voltage wiring line is adjacent to the wiring line in the second direction.
Clause 12. The semiconductor device of Clause 11, wherein at least one of an input voltage or an output voltage of a high-voltage circuit provided by the high-voltage cell is applied to the high-voltage wiring line.
Clause 13. A semiconductor device comprising:
   a plurality of power lines disposed in a plurality of tracks extending along a first direction, parallel to an upper surface of a substrate, and disposed along a second direction, intersecting the first direction;
   a plurality of standard cells disposed between a pair of closest adjacent tracks separated by a first interval in the second direction, among the plurality of tracks; and
   at least one high-voltage cell disposed between a pair of tracks, among the plurality of tracks, separated by a second interval, greater than the first interval, in the second direction,
   wherein at least one additional track other than the pair of tracks is disposed in the at least one high-voltage cell,
   wherein a wiring line disposed on the additional track and extending along the first direction is separated from the plurality of power lines, and
   a voltage of the wiring line disposed on the additional track is different from a voltage of a pair of power lines disposed on the pair of tracks.
Clause 14. The semiconductor device of Clause 13,
   wherein a plurality of additional tracks are disposed between the pair of tracks in the high-voltage cell, and
   a voltage of the wiring line disposed in the at least one additional track, among the plurality of additional tracks, is greater than a voltage of the plurality of power lines.
Clause 15. The semiconductor device of Clause 14, wherein a voltage of each of wiring lines disposed in the plurality of additional tracks are different from each other.
Clause 16. The semiconductor device of Clause 14 or Clause 15,
   wherein the at least one additional track is disposed on a well region of the substrate, and the well region is doped with an N-type impurity.
Clause 17. The semiconductor device of any of Clauses 13-16, wherein the high-voltage cell provides a level shifter.
Clause 18. A semiconductor device comprising:
   a core region operating by a first power supply voltage; and
   a high voltage (HV) region be operating by a voltage, greater than the first power supply voltage, wherein the core region includes a plurality of standard cells disposed along a first direction and a second direction, parallel to an upper surface of a substrate and intersecting each other, and the HV region includes a plurality of high-voltage cells disposed along the first direction and the second direction, and
   each of the plurality of standard cells has a first height in the second direction, and each of the plurality of high-voltage cells has a second height that is an integer multiple of the first height in the second direction.
Clause 19. The semiconductor device of Clause 18,
   wherein each of the plurality of high-voltage cells comprises a plurality of power lines and a plurality of wiring lines, extending in the first direction,
   some of the plurality of power lines extend along boundaries between the plurality of high-voltage cells, and the plurality of wiring lines extend across the interior of the plurality of high-voltage cells.
Clause 20. The semiconductor device of Clause 19, wherein each of the plurality of high-voltage cells comprises a pair of boundaries extending along the first direction, and a pair of power lines extending along the pair of boundaries, among the plurality of power lines, transmit the same power supply voltage.

## Claims

1. A semiconductor device comprising:
a plurality of power lines extending along a first direction, parallel to an upper surface of a substrate, and disposed along a second direction intersecting the first direction;
a plurality of standard cells disposed along the first direction and the second direction, respectively having a reference height corresponding to a reference interval between a pair of power lines that are adjacent to each other in the second direction, the pair of power lines being configured to supply different power supply voltages; and
a high-voltage cell having a height that is an integer multiple of the reference height, the high-voltage cell being disposed between the plurality of standard cells,
wherein the high-voltage cell includes at least one wiring line disposed at a height of the plurality of power lines in a third direction, the third direction being perpendicular to the upper surface of the substrate, and
wherein the at least one wiring line is disposed in a position equal to a position of a neighboring power line of the plurality of power lines in the second direction and is physically separated from the neighboring power line in the first direction.

2. The semiconductor device of claim 1,
wherein the high-voltage cell is disposed at a pair of first boundaries extending along the first direction and at a pair of second boundaries extending along the second direction, and
wherein two power lines of the plurality of power lines are disposed along the first boundaries.

3. The semiconductor device of claim 2, wherein the two power lines are configured to supply power supply voltages having a same voltage magnitude.

4. The semiconductor device of any preceding claim,
wherein the at least one wiring line includes:
a first wiring line disposed in a position equal to a position of a first neighboring power line of the plurality of power lines, in the second direction, and
a second wiring line disposed in a position equal to a position of a second neighboring power line of the plurality of power lines, in the second direction, and
wherein the first wiring line and the second wiring line are disposed at different positions in the second direction.

5. The semiconductor device of claim 4, wherein the first wiring line is configured to supply a voltage having a first magnitude and the second wiring line is configured to supply a voltage having a second magnitude that is different from the first magnitude.

6. The semiconductor device of claim 4 or claim 5, wherein a length of the first wiring line in the first direction is different from a length of the second wiring line in the first direction.

7. The semiconductor device of any of claims 4-6, wherein a distance between the first neighboring power line and the first wiring line in the first direction is different from a distance between the second neighboring power line and the second wiring line in the first direction.

8. The semiconductor device of any preceding claim,
wherein the high-voltage cell comprises a first well region and a second well region that are disposed at different positions in the first direction, and
wherein, in the third direction, the first well region is disposed beneath the at least one wiring line, and the second well region is disposed beneath the neighboring power line.

9. The semiconductor device of claim 8, wherein the second well region is included in at least one standard cell adjacent to the high-voltage cell in the first direction.

10. The semiconductor device of claim 8 or claim 9, wherein an impurity concentration of the first well region is different from an impurity concentration of the second well region.

11. The semiconductor device of any preceding claim,
wherein the high-voltage cell further comprises a high-voltage wiring line configured to receive a high voltage,
wherein a magnitude of the high voltage is higher than a magnitude of the power supply voltages supplied by the plurality of power lines, and
wherein the high-voltage wiring line is adjacent to the at least one wiring line in the second direction.

12. The semiconductor device of claim 11, wherein the high-voltage wiring line is configured to receive at least one of an input voltage or an output voltage of a high-voltage circuit provided by the high-voltage cell.

13. The semiconductor device of any preceding claim, wherein the plurality of power lines are disposed in a plurality of tracks extending along the first direction,
wherein the plurality of standard cells are disposed between a pair of closest adjacent tracks separated by a first distance in the second direction, among the plurality of tracks, and
wherein the high-voltage cell is disposed between a pair of tracks, among the plurality of tracks, separated by a second distance, greater than the first distance, in the second direction.

14. The semiconductor device of claim 13, wherein at least one additional track other than the pair of tracks is disposed in the at least one high-voltage cell.

15. The semiconductor device of any preceding claim, wherein the high-voltage cell is provided as a level shifter.
